(19) Europäisches Patentamt
European Patent Office
Office européen des brevets

(11) Publication number: **0 333 156**
**A2**

(12) **EUROPEAN PATENT APPLICATION**

(21) Application number: 89104582.5

(51) Int. Cl.4: G03C 1/68 , G03F 7/10

(22) Date of filing: 15.03.89

(30) Priority: 16.03.88 JP 62823/88
18.03.88 JP 65039/88

(43) Date of publication of application:
20.09.89 Bulletin 89/38

(84) Designated Contracting States:
DE FR GB

(71) Applicant: FUJI PHOTO FILM CO., LTD.
210 Nakanuma Minami Ashigara-shi
Kanagawa 250-01(JP)

(72) Inventor: Kita, Nobuyuki
c/o Fuji Photo Film Co., Ltd. 4000, Kawashiri
Yoshida-cho Haibara-gun Shizuoka-ken(JP)
Inventor: Koizumi, Shigeo
c/o Fuji Photo Film Co., Ltd. 4000, Kawashiri
Yoshida-cho Haibara-gun Shizuoka-ken(JP)

(74) Representative: Patentanwälte Grünecker,
Kinkeldey, Stockmair & Partner
Maximilianstrasse 58
D-8000 München 22(DE)

# (54) Lithographic plate necessitating no dampening water.

(57) The present invention relates to a lithographic plate necessitating no damping water, which has an excellent image reproducibility, which can be treated with a developer mainly comprising water or an aqueous alkali solution, and whose sensitivity is not changed at exposure temperature. The present plate comprises, on a support, a photosensitive layer and a silicone rubber layer in this order, the silicone rubber layer being formed by addition reaction of an ⋗SiH group with a -CH=CH- group to cause crosslinking, and said photosensitive layer comprising a water-soluble or aqueous alkali solution-soluble photosensitive polymer having, in its side chain,

(1) at least two groups represented by the following formulae (I) to (III):

EP 0 333 156 A2

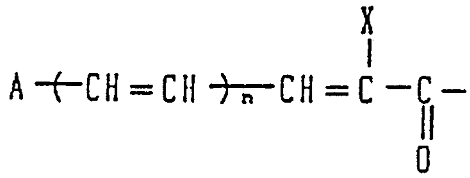

( I )

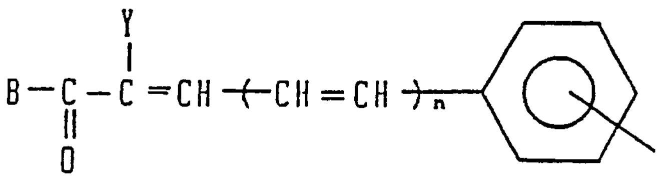

( II )

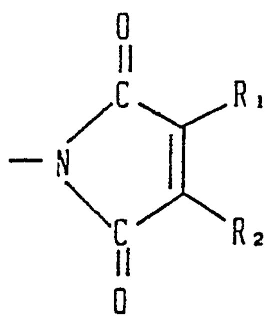

(III)

wherein

A represents an aryl group, a substituted aryl group, a furyl group or a thienyl group,

B represents a hydroxyl group, an alkoxy group, aryl group, a substituted aryl group or an alkyl group,

X represents H, CN, a halogen atom, a phenyl group, an alkyl group or $-\underset{\underset{O}{\|}}{C}-$,

Y represents H, CN, a halogen atom, a phenyl group or an alkyl group,

n represents 0 or 1, and

$R_1$ and $R_2$ each represents an alkyl group or $R_1$ and $R_2$ may together form a five-membered or six-membered ring, and

(2) at least one carboxylic acid group or its salt.

# Lithographic Plate Necessitating No Dampening Water

## BACKGROUND OF THE INVENTION

### Field of the Invention

The present invention relates to a lithographic plate which requires no dampening water in the printing.

### Description of the Prior Art

Several lithographic plates which require no dampening water in the printing (hereinafter referred to as "waterless lithographic plates") have been already invented. These inventions are described in, for example, Japanese Patent Publication for Opposition Purpose (hereinafter referred to as "J. P. KOKOKU") Nos. 44-23042, 46-16044, 51-17081, 54-26923 and 55-22781 and Japanese Patent Unexamined Published Application (hereinafter referred to as "J. P. KOKAI") No. 56-80064. Among them, the positive working waterless lithographic plates are classified into two types, i.e. one type having a photopolymerizable photosensitive layer as described in J. P. KOKOKU Nos. 54-26923 and 56-23150 and the other type having a photodimerizable photosensitive layer as described in J. P. KOKOKU No. 55-22781.

The waterless lithographic plates having the photopolymerizable photosensitive layer require no adhesion assistant (such as a silane coupling agent) which is usually added to the silicone rubber layer in order to assist the adhesion of the rubber layer to the photosensitive layer, because the photo-adhesion occurs between the silicone rubber layer and the photosensitive layer upon the exposure. In case such a photo-adhesion method is employed, only the unexposed part of the silicone rubber layer can be removed without dissolving the photopolymerization layer below it by using a solvent capable of swelling the silicone rubber layer as a developer. However, since the image is formed by essentially the photo-adhesion in this process, the halftone dot reproducibility in the shadow portion in which the quantity of light is insufficient, is not always satisfactory. A process for solving this problem has been proposed wherein an adhesion assistant such as an aminosilane coupling agent is incorporated in the silicone rubber layer so that the silicone rubber layer is firmly bonded with the photosensitive layer and a developer capable of dissolving the photosensitive layer is used to dissolve the unexposed part of the photosensitive layer together with the silicone rubber layer covering it. However, in this process, the halftone dot reproducibility in the highlight portion becomes poor due to the reduction in developability, because the photosensitive layer is strongly adhered to the silicone layer with the elapse of time, although the halftone dot reproducibility of the shadow portion is improved. When the photopolymerizable photosensitive layer is used, the sensitivity is changed seriously by the exposure temperature or over the time of leaving it to stand after the exposure until the development. This problem is important particularly in step and repeat exposure.

In the lithographic plate having a photo-dimerizable photosensitive layer, unlike that having the photopolymerizable layer, it is necessary to incorporate an adhesion assistant such as a silane coupling agent in the silicone rubber layer in order to previously bond the silicone rubber layer firmly with the photosensitive layer, because sufficient photo-adhesion cannot be obtained. Although the defect of the photo-polymerizable photosensitive layer that the sensitivity is seriously changed by the exposure temperature or during the time of leaving it to stand after the exposure until the development, is overcome, it has another defect that the halftone dot reproducibility in the highlight portion is deteriorated with the elapse of time as observed in the photopolymerizable photosensitive layer, because the silane coupling agent is used as an adhesion assistant.

### Summary of the Invention

Therefore, the object of the present invention is to provide a waterless lithographic plate which has an excellent image reproducibility, which can be treated with a developer mainly comprising water or an aqueous alkali solution, and whose sensitivity is not changed at the exposure temperature.

The inventor has found out that the above object can be easily attained by a waterless lithographic plate comprising, on a support, a photosensitive layer and a silicone rubber layer in this order, having an excellent image reproducibility and being able to be treated with a developer mainly comprising water or an

aqueous alkali solution, and the sensitivity of said plate being scarcely changed by the environmental conditions in the exposure, the silicone rubber layer being formed by addition reaction of an ⋟SiH group with a -CH=CH- group to cause crosslinking, and the photosensitive polymer comprising a photopolymerizable unsaturated double bond group and a carboxylic acid group or its salt group. The present invention has been completed on the basis of this finding.

Namely, the present invention relates to a lithographic plate necessitating no dampening water which comprises, on a support, a photosensitive layer and a silicone rubber layer in this order, the rubber layer being formed by addition reaction of an ⋟SiH group with a -CH=CH- group to cause crosslinking, and the photosensitive layer comprising a water-soluble or aqueous alkali solution-soluble photosensitive polymer having, in its side chain, the following groups:

(a) at least two groups represented by the following general formulae (I) to (III):

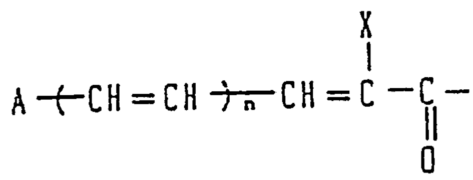

· · · (I)

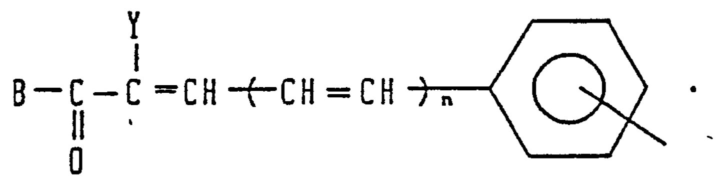

· · · (II)

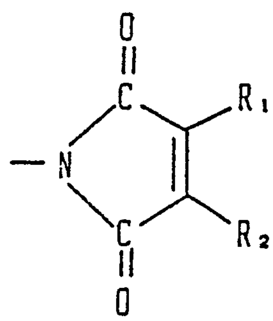

· · · (III)

wherein
A represents an aryl group, a substituted aryl group, a furyl group or a thienyl group,
B represents a hydroxyl group, an alkoxy group, an aryl group, a substituted aryl group or an alkyl group,
X represents a hydrogen atom, a CN group, a halogen atom, a phenyl group, an alkyl group or a $-\underset{\overset{\|}{O}}{C}-$ group,
Y represents a hydrogen atom, a CN group, a halogen atom, a phenyl group or an alkyl group,
n represents 0 or 1, and
$R_1$ and $R_2$ each represents an alkyl group, or $R_1$ and $R_2$ may together form a five-membered or six-membered ring,
and

(b) at least one carboxylic acid group or its salt.

Detailed Description of the Invention

The waterless lithographic plate of the present invention must have a flexibility sufficient for setting it in

an ordinary printer and a sufficient resistance to a load applied at the time of the printing. Typical examples of a support include coated papers, metal sheets, plastic films such as polyethylene terephthalate films, rubber sheets and composite materials of them. The surface of such a support may be coated with a primer layer and other layers, in order to prevent halation or for other purposes.

The primer layer is prepared, for example, by forming a layer of a photosensitive polymer as described in J. P. KOKAI No. 60-229031 and exposing and curing it, prior to the formation of the photosensitive layer; by thermosetting an epoxy resin described in J. P. KOKAI No. 62-50760; or by hardening a gelatin layer described in J. P. KOKAI No. 63-133153. Further, the primr layer is prepared by hardening a casein layer. The primer layer may contain additives such as dyes, printing-out agents, polymerizable monomers usable as photo-adhesives and polymerization initiators for preventing the halation or the like. The thickness of the primer layer thus formed is 2 to 10 g/m$^2$.

The water-soluble or aqueous alkali solution-soluble photosensitive polymer of the present invention has, in its side chain, at least two groups represented by the above general formulae (I) to (III) and also at least one carboxylic acid group or its salt.

The polymer having at least two groups represented by the general formula (I) or (II) in its side chain includes, for example, copolymers of (1) an acrylic ester, methacrylic ester or vinyl ether compound with (2) and $\alpha,\beta$-unsaturated carboxylic acid and, if necessary, (3) an addition-polymerizable vinyl monomer, as described in J. P. KOKAI No. 62-175730. The acrylic esters, methacrylic esters and vinyl ether compounds having the group of the formula (I) or (II) include those described in J. P. KOKOKU No. 49-28122, British Patent No. 1,363,214, J. P. KOKAI No. 47-34794, J. P. KOKOKU Nos. 50-11283 and 51-481, J. P. KOKAI No. 49-36794, J. P. KOKOKU Nos. 56-52923, 55-31452 and 57-56485, J. P. KOKAI Nos. 50-24384 and 49-10397, J. P. KOKOKU Nos. 56-37244, 55-44930 and 47-13776, British Patent No. 1,314,689, J. P. KOKOKU Nos. 49-14352, 50-24621 and 57-28488, and J. P. KOKAI Nos. 50-22850 and 46-3147. Specifically, those monomers include:

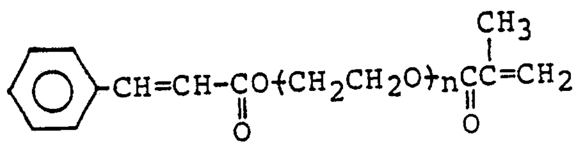

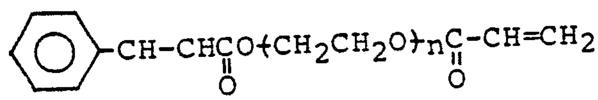

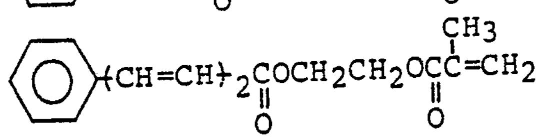

, and

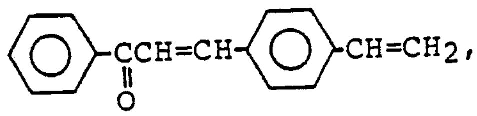

wherein n is usually 1 - 10, preferably 1 - 4.

The above photosensitive polymer also covers those soluble in an aqueous alkali solution. Such a polymer includes acrylic or methacrylic esters having a group of the above formula (I) or (II) and a carboxyl group, such as the homopolymers of monomers and the copolymers of these monomers with another monomer, as described in J. P. KOKOKU No. 51-482 and J. P. KOKAI No. 49-36794; those produced by changing a compound having a group of the above formula (I) or (II) and a hydroxyl group or amino group, to an adduct with a copolymer having an acid anhydride group such as additives thereof with a maleic anhydride copolymer described in U. S. Patent Nos. 2,816,091, 2,824,087, 2,811,509 and 2,751,373; a reaction product of a polymer having a hydroxyl group with a compound represented by the formula:

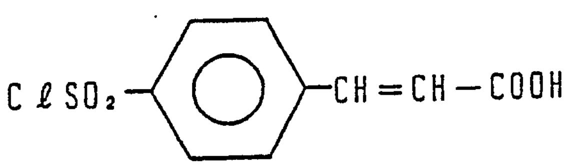

;

products produced by reacting a polymer having a hydroxyl group or amino group with a compound represented by the formula:

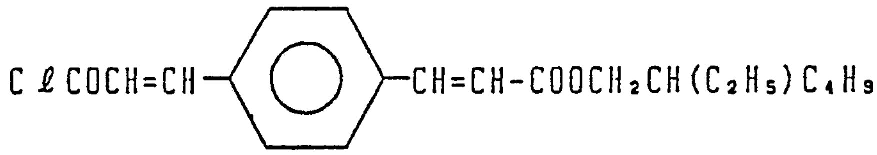

and saponifying the reaction product with an alkali, to convert the terminal group into a carboxyl group; products produced by reacting a polyvinyl alcohol derivative with a compound of the formula:

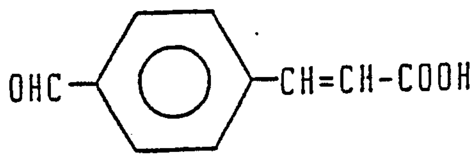

;

products produced by reacting a part of the carboxyl groups of an acrylic or methacrylic acid copolymer with a compound having a group of the above formula (I) or (II) and -NCO, -OH, $-CH_2CH\underset{O}{—}CH_2$ or $NH_2$ group; products produced by reacting a polymeric compound having a carboxyl group and hydroxyl group with a compound having a group having the above formula (I) or (II) and NCO, -COCl or a cyclic acid anhydride group; polyester polymers produced from dimethylolpropionic acid and

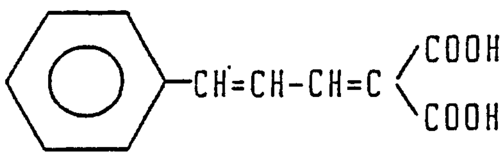

.

or its diester; polyurethanes produced by reacting a glycol having a hydroxyl group at both ends, which glycol is prepared from 2 mol of dimethylolpropionic acid and 1 mol of a compound of the formula:

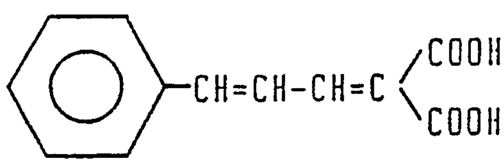

)

with a diisocyanate; and polyurethanes produced by reacting a diisocyanate with a diol prepared from a compound having two hydroxyl groups (obtained by reacting epoxy resin with cinnamic acid) and dimethylolpropionic acid.

Further, the above polymer covers a photosensitive polymer produced by partially adding an active mercaptocarboxylic acid to a polymer having no carboxylic acid group but having at least two groups of the above general formula (I) or (II), in its side chain, are also usable.

The photosensitive polymer having a carboxylic acid group in its side chain may be solubilized in water by neutralizing it with sodium hydroxide, potassium hydroxide or an amine to form a salt.

The photosensitive polymer has a molecular weight of preferably 2,000 to 500,000, more preferably 10,000 to 150,000. This polymer has an acid value preferably of 20 to 200. When the acid value is less than 20, its solubility in an aqueous alkali solution is reduced unfavorably.

The photosensitive polymer having a group represented by the above general formula (III) in its side chain is described in, for example, J. P. KOKAI No. 52-988 (corresponding to U. S. Patent No. 4,079,041), West German Patent No. 2,626,769, European Patent Nos. 21,019 and 3,552, Die Angewandte Mackromolekulare Chemie 115 (1983), pages 163 to 181, J. P. KOKAI Nos. 49-128991 to 49-128993, 50-5376 to

50-5380, 53-5298 to 53-5300, 50-50107, 51-47940, 52-13907, 50-45076, 52-121700, 50-10884 and 50-45087, and West German Patent Nos. 2,349,948 and 2,616,276.

Among them, a photosensitive polymeric compound having, in its side chain, two or more maleimido groups and at least one carboxylic acid group or its salt are used in the present invention.

The groups $R_1$ and $R_2$ in the general formula (III) are preferably an alkyl group having 1 to 4 carbon atoms, particularly a methyl group. The alkyl group may have a substituent.

The molecular weight of the polymer is preferably at least 1,000, more preferably 10,000 to 500,000.

This polymer is easily produced by, for example, copolymerizing a monomer having the following formulae (IV) to (VI):

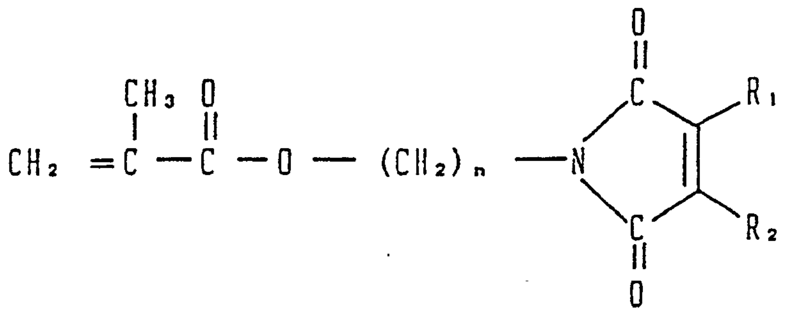 ... (IV)

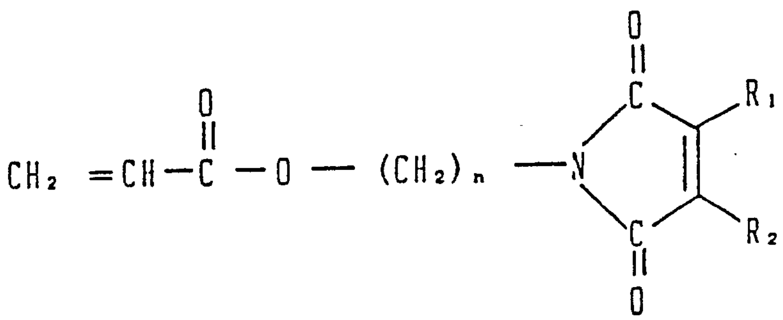 ... (V)

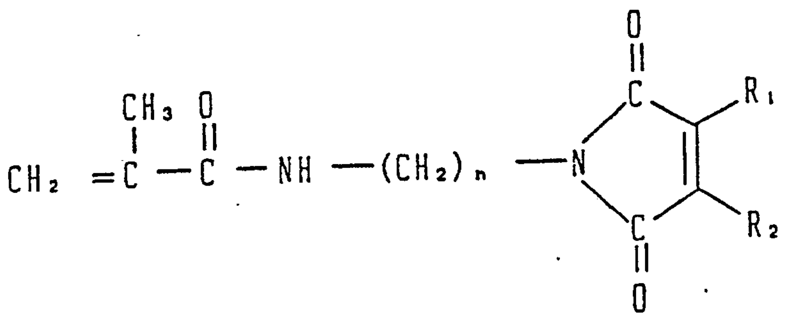 ... (VI)

wherein $R_1$ and $R_2$ are as defined above, and n represents an integer of preferably 1 to 6, with a monomer having a carboxyl group such as acrylic, methacrylic, crotonic or itaconic acid. Such a copolymer can be further neutralized with sodium hydroxide, potassium hydroxide or an amine to form its salt.

The copolymerization may be further conducted in the presence of with another monomer, if necessary. Such a monomer includes, for example, hydroxyalkyl methacrylates, hydroxyalkyl acrylates, alkyl methacrylates, alkyl acrylates, benzyl methacrylate, allyl methacrylate, acrylonitrile, styrene, aminoalkyl methacrylates and, quaternary aminoalkyl methacrylates.

Among them, a copolymer of N-[2-(methacryloyloxy)ethyl]-2,3-dimethyl maleimide with methacrylic acid or acrylic acid, as described in Die Angewandte Mackromolekulare Chemie 128 (1984), pages 71 to 91, are preferred. In addition, a multi-component copolymer prepared by conducting the copolymerization in the presence of a vinyl monomer which is different from the above-described vinyl monomers are also preferred.

The acid value of the polymer having the group represented by the formula (III) is preferably 20 to 200, before the neutralization. The molecular weight of the polymer is at least 1,000, preferably 10,000 to

500,000 and particularly 20,000 to 300,000.

If necessary, sensitizers such as a photosensitizer capable of sensitizing the photosensitive polymer may be incorporated in the photosensitive layer.

The photosensitizer to be used in combination with the photosensitive polymer having the group represented by the formula (I) or (II) includes, for example, benzophenone derivatives, benzanthrone derivatives, quinones, aromatic nitro compounds, naphthothiazoline derivatives, benzothiazoline derivatives, thioxanthones, ketocoumarin compounds, naphthofuranon compounds, pyrylium salts and thiapyrylium salts. In particular, the photosensitizer includes, for example, Michler's ketone, N,N′-diethylaminobenzophenone, benzanthrone, (3-methyl-1,3-diaza-1,9-benz)anthrone picramide, 5-nitroacenaphthene, 2-chlorothioxanthone, 2-isopropylthioxanthone, dimethylthioxanthone, methylthioxanthone-1-ethyl carboxylate, 2-nitrofluorenone, 2-dibenzoylmethylene-3-methylnaphthothiazoline, 3,3-carbonyl-bis(7-diethylaminocoumarine), and 2,4,6-triphenylthiapyrylium perchlorate.

The amount of the photosensitizer to be added is 1 to 20 wt.%, preferably 3 to 10 wt.% based on the total photosensitive layer composition.

The sensitizers to be used in combination with the present photosensitive polymer having the group represented by the formula (III) include, for example, benzoin, benzoin methyl ether, benzoin ethyl ether, 2,2-dimethoxy-2- phenylacetophenone, 9-fluorenone, 2-chloro-9-fluorenone, 2-methyl-9-fluorenone, 9-anthrone, 2-bromo-9-anthrone, 2-ethyl-9-anthrone, 9,10-anthraquinone, 2-ethyl-9,10-anthraquinone, 2-t-butyl-9,10-anthraquinone, 2,6-dichloro-9,10-anthraquinone, xanthone, 2-methylxanthone, 2-methoxyxanthone, dibenzalacetone, p-(dimethylamino)phenyl styryl ketone, p-(dimethylamino)phenyl p-methylstyryl ketone, benzophenone, p-(dimethylamino)benzophenone (or Michler's ketone), p-(diethylamino)benzophenone and benzanthrone.

Further, the sensitizers include thioxanthone derivatives such as 2-chlorothioxanthone, 2-isopropylthioxanthone and dimethylthioxanthone; substituted thioxanthones described in German Patent Nos. 3,018,891 and 3,117,568, European Patent No. 33730 and British Patent No. 2,075,506; and compounds of the following general formula (V):

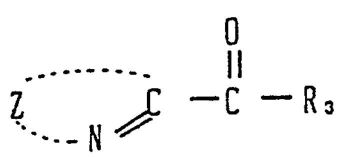

(V)

In the above general formula (V), Z represents a non-metallic atomic group necessary for forming a heterocyclic nucleus including a nitrogen atom. The heterocyclic nuclei having a nitrogen atom which are formed from Z include, for example, thiazoles such as benzothiazole, α-naphthothiazole and β-naphthothiazole; oxazoles such as benzoxazole and β-naphthoxazole; selenazoles such as benzoselenazole; imidazoles such as imidazole per se and benzimidazole; isoindoles such as 3,3-dimethylindolenine; quinolines such as quinoline per se and isoquinoline; diazoles such as 1,3,4-oxadiazole, 1,3,4-thiadiazole and 1,3,4-selenadiazole; triazoles such as 1,2,4-triazole; as well as pyrazine; quinoxaline; S-triazine and phenanthridine. The heterocyclic nucleus including a nitrogen atom and Z may have a substituent. The substituent includes an alkyl group having 1 to 6 carbon atoms such as a methyl and ethyl group; an alkoxy group having 1 to 6 carbon atoms such as a methoxy and ethoxy group; a halogen atom such as a chlorine and bromine atom; a cyano group; an amino group; an amino group substituted with an alkyl group having 1 to 4 carbon atoms such as a dimethylamino group; a carboalkoxy group having an alkyl group having 1 to 4 carbon atoms such as a carbomethoxy group; and an unsubstituted or substituted aryl group having 6 to 10 carbon atoms such as a phenyl group, a p-methoxyphenyl and p-chlorophenyl group.

When $R_3$ represents an aryl group, it is a monocyclic or polycyclic group having 6 to 14 carbon atoms such as a phenyl or naphthyl group. When $R_3$ represents a substituted aryl group, the substituent includes, for example, an alkyl group having 1 to 6 carbon atoms, an alkoxy group having 1 to 6 carbon atoms, an aryl group having 6 to 10 carbon atoms, an amino group, an amino group substiuted with an alkyl group having 1 to 6 carbon atoms, and a halogen atom such as a fluorine atom, a chlorine atom and a bromine atom. The alkyl substituent may be further substituted with an alkoxy group having 1 or 2 carbon atoms such as a methoxy or ethoxy group or a halogen atom such as a chlorine atom.

Preferred examples of the aryl group as a substituent include a alkyl group having 1 to 4 carbon atoms such as a methyl and ethyl group; an alkoxy group having 1 to 4 carbon atoms such as a methoxy and ethoxy group; an amino group substituted with an alkyl group having 1 to 4 carbon atoms such as a

dimethylamino and diethylamino group; and a halogen atom such as a fluorine atom, a chlorine atom and a bromine atom.

When $R_3$ represents a substituted or unsubstituted heterocyclic group, the heterocyclic group is a monocyclic or polycyclic group having at least one of nitrogen, oxygen and sulfur atoms. It is preferably a five-membered or six-membered aromatic heterocyclic group derived from furan, pyrrole or pyridine.

The substituent for the heterocyclic group is the same as the above-described substituent for the aryl group.

The sensitizer may be used either singly or as a combination of them. The amount of the sensitizer used is preferably 0.5 to 20%, more preferably 3 to 10%, based on the total composition for forming the photosensitive layer.

It is suitable to incorporate a thermal polymerization inhibitor in the photosensitive layer. The thermal polymerization inhibitor usable herein includes, for example, hydroquinone, p-methoxyphenol, di-t-butyl-p-cresol, pyrogallol, t-butylcatechol, benzoquinone, 4,4′-thiobis(3-methyl-6-t-butylphenol), 2,2′-methylenebis(4-methyl-6-t-butylphenol), and 2-mercaptobenzimidazole.

If necessary, a dye or a pigment can be added in order to color the photosensitive layer or a pH indicator can be added as a printing-out agent.

In the process wherein the photosensitive layer and the silicone rubber layer, which will be explained fully below, are removed in the image area in the development step after the image exposure, the photosensitive layer is preferably as thin as possible. Usually, the thickness is less than 5 μ, particularly 0.1 to 1 μ.

The silicone rubber layer of the present invention serves as a printing ink-repelling layer. When the thickness of this layer is insufficient, problems such as reduction of the repalling power and easy scarring occur and, on the contrary, when the thickness is excess, the developability is reduced. Therefore, the thickness is preferably 0.5 to 5 μ.

The silicone rubber layer used in the present invention is formed by addition reaction between an ⋟SiH group and a -CH=CH- group to cause crosslinking. The silicone rubber layer thus formed has a characteristic feature that it has an excellent ink-repellency unlike a condensed type silicone rubber layer. Further, it has an excellent adhesion to the photosensitive layer of the present invention. In addition, the silicone rubber layer formed by the addition reaction is sufficiently cured even though a carboxylic acid is present in the photosensitive layer, while that formed by the condensation reaction cannot be cured sufficiently in the presence of the carboxylic acid. Since the photosensitive layer can contain a carboxylic acid as stated in the above, the development can be conducted with a developer mainly comprising water or an aqueous alkali solution.

Group -CH=CH- includes an unsubstituted or substituted alkenyl, alkenylene, alkynyl and alkynylene group having 2 to 10 carbon atoms. Aromatic -CH=CH- group is excluded.

The silicone rubber of the present invention is produced by reacting a polyvalent hydrogenorganopolysiloxane with a polysiloxane compound having two or more -CH=CH- bonds in the molecule. It is produced preferably by corsslinking and thereby curing a composition comprising:

(1) 100 parts by weight of an organopolysiloxane having at least two alkenyl groups (preferably vinyl groups) directly bonded with the silicone atom in the molecule,

(2) 0.1 to 1,000 parts by weight of an organohydrogenpolysiloxane having at least two ⋟SiH bonds in the molecule, and

(3) 0.00001 to 10 parts by weight of an addition catalyst.

The alkenyl group of Component (1) may be at any position in the molecule such as its chain end or its middle portion. Organic groups other than the alkenyl group include unsubstituted or substituted alkyl and aryl groups. Component (1) may have only a very small amount of a hydroxyl group. Component (2) reacts with Component (1) to form the silicone rubber and serves also as an adhesive for the photosensitive layer. A hydrogen atom of Component (2) may be at any position in the molecule such as its chain end or its middle portion. The organic groups are the same as those of Component (1). It is preferred that at least 60% of the organic groups of Components (1) and (2) is a methyl group from the viewpoint of the improvement of the ink repellency. Components (1) and (2) may be any of straight, cyclic and branched chain structures. In view of the physical properties of the rubber, it is preferred that the molecular weight of at least one of Components (1) and (2) exceeds 1,000. It is further preferred that the molecular weight of Component (1) exceeds 1,000.

Examples of Component (1) include α,ω-divinylpolydimethylsiloxane and methylvinylsiloxane/dimethylsiloxane copolymer having methyl groups at both ends thereof. Examples of Component (2) include polydimethylsiloxane having hydrogen atoms at both ends thereof, α,ω-dimethyl-

polymethylhydrogensiloxane, methylhydrogensiloxane/dimethylsiloxane copolymer having methyl groups at both ends thereof and cyclic polymethylhydrogensiloxane.

The addition catalyst (3) is selected from known ones. Particularly, platinum compounds are preferred. They include, for example, platinum per se, platinum chloride, chloroplatinic acid and olefin-coordinated platinum. For controlling the hardening velocity of the composition, a crosslinking inhibitor such as an organopolysiloxane having a vinyl group, e.g. tetracyclo(methylvinyl)siloxane or an alcohol having carbon-to-carbon triple bond may be incorporated in the composition.

The addition reaction takes place and the hardening starts when the three components of the composition are mixed together. The hardening velocity is increased rapidly as the reaction temperature is elevated. Therefore, for stabilizing the adhesion power to the photosensitive layer, it is desirable to prolong the pot life of the composition in the step of converting it into the rubber and to reduce the hardening time on the photosensitive layer by conducting the hardening of the composition at such a temperature that the characters of the support and the photosensitive layer are not changed for a period of time sufficient for the complete hardening.

Further, the following compounds can be added: known adhesive agents such as alkenyltrialkoxysilanes; organopolysiloxanes having a hydroxyl group (condensed type silicone rubber); and silanes (or siloxanes) having a hydrolyzable functional group. In addition, a known filler such as silica can be added in order to improve the rubber strength.

Various silicone rubber layers can be formed on the characteristic silicone rubber layer of the present waterless lithographic plate. A bonding layer can be formed between the photosensitive layer and the silicone rubber layer, in order to increase the adhesion between the photosensitive layer and the silicone rubber layer and to prevent poisoning of the catalyst in the silicone rubber composition. To protect the surface of the silicone rubber layer, the silicone rubber layer may be laminated with a transparent film such as polyethylene, polypropylene, polyvinyl chloride, polyvinylidene chloride, polyvinyl alcohol, polyethylene terephthalate or cellophane or it may be coated with a polymer.

The waterless lithographic plate of the present invention is exposed through a transparent original and then the image area is developed with a developer capable of dissolving or swelling the image area of the photosensitive layer or a developer capable of swelling that area of the silicone rubber layer. In this step, both of the photosensitive layer and the silicone rubber layer formed thereon in the image area are removed or, alternatively, only the silicone rubber layer in that area is removed. Which way may be selected depends on the strength of the developer.

The developers usable in the present invention are those known as the developers for the waterless photosensitive lithographic plates. They include, for example, aliphatic hydrocarbons such as hexane, heptane, 'Isopar E, H or G' (trade names of aliphatic hydrocarbons of Esso Kagaku Co., Ltd.), gasoline and kerosene; aromatic hydrocarbons such as toluene and xylene; and halogenated hydrocarbons such as trichloroethylene to which the following polar solvent is added.

Alcohols (such as methanol, ethanol and benzyl alcohol),
Ethers (such as methyl cellosolve, ethyl cellosolve, butyl cellosolve, methyl carbitol, ethyl carbitol, butyl carbitol and dioxane),
Ketones (such as acetone and methyl ethyl ketone), and
Esters (such as ethyl acetate, methyl cellosolve acetate, cellosolve acetate and carbitol acetate).

Water may be added to the above organic solvent used as the developer or the organic solvent may be solubilized in water with a surfactant. Further, an alkali such as sodium carbonate, monoethanolamine, diethanolamine, triethanolamine, sodium silicate, potassium silicate, sodium hydroxide, potassium hydroxide or sodium borate may be added to the organic solvent. In some cases, even city water or an aqueous alkali solution may be used as the developer.

A dye such as Crystal Violet or Astrazone Red can be added to the developer in order to dye the image area simultaneously with the development.

The development can be conducted by a known process which comprises rubbing the lithographic plate with a developing pad containing the above-described developer or pouring the developer on the plate surface, followed by rubbing it with a developing brush. By this treatment, the silicone rubber layer and the photosensitive layer in the image area are removed to expose the surface of the base or primer layer, thereby to form the ink-receiving area. Alternatively, only the silicone rubber layer in the image area is removed to expose the photosensitive layer, thereby forming the ink-receiving area.

The waterless lithographic plate of the present invention comprises, on the support, the photosensitive layer and the layer of silicone rubber capable of closslinking by the addition reaction in this order. This plate is characterized in that the photosensitive layer comprises a water-soluble or aqueous alkali solution-soluble photosensitive polymer having, in its side chain, at least two groups represented by the formulae (I) to (III) and at least one carboxylic acid group or its salt. Therefore, the waterless lithographic plate of the present invention has the following merits: its sensitivity is substantially unchanged by the printing conditions, it can be treated with a relatively mild developer, and its image reproducibility is not deteriorated with the elapse of time.

The following examples will further illustrate the present invention, which by no means limit the invention.

Example 1

A composition for forming a primer layer which comprised the following components was applied to a smooth aluminum sheet having a thickness of 0.3 mm, which had been degreased by an ordinary method, in an amount of 8.0 g/m² (on dry basis) and then it was heated at 120°C for 2 min to dry and cure the coating film:

| | |
|---|---|
| Milk casein | 98 parts by weight |
| Glyoxal solution (40% aqueous solution; a product of Wako Junyaku Kogyo Co., Ltd.) | 2 parts by weight |
| γ-Glycidoxypropyltri(β-methoxyethoxy)silane | 3 parts by weight |
| 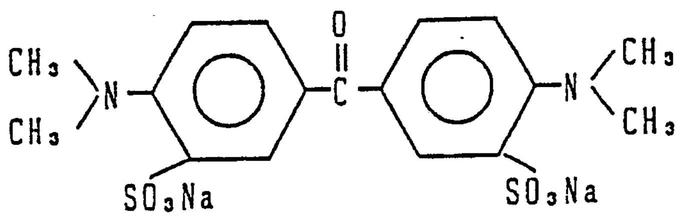 | 5 parts by weight |
| Potassium hydroxide | 4 parts by weight |
| Pure water | 2000 parts by weight |

The aluminum sheet having the primer layer formed thereon was immersed in a dyeing solution having the following composition to dye it, then washed with water, and dried at room temperature:

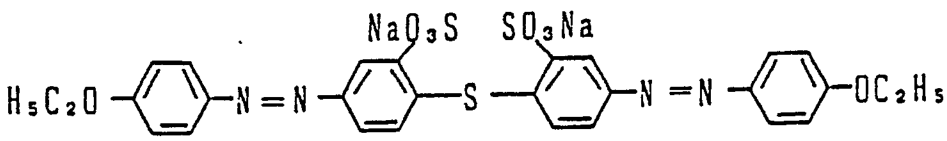

| | |
|---|---|
| | 1 part by weight |
| Pure water | 2000 parts by weight |

A photosensitive composition comprising the following components was applied, in an amount of 1 g/m² (on dry basis), to the aluminum plate having the dyed primer layer formed thereon and then dried at

1000 °C for 1 min:

| | |
|---|---|
| β-Cinnamoyloxyethyl methacrylate/methacrylic acid copolymer (weight ratio: 90:10, acid value: 61, molecular weight determined by GPC: 48,000) | 5 parts by weight |
| 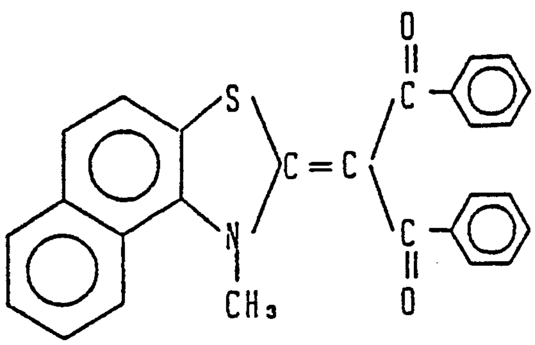 | 0.2 part by weight |
| $PF_6$ salt of condensate of p-diazodiphenylamine and formaldehyde | 0.1 part by weight |
| Diethyl phthalate | 0.5 part by weight |
| F-177 (fluorine-containing nonionic surfactant: a product of Dainippon Ink & Chemicals, Inc.) | 0.02 part by weight |
| Crystal Violet | 0.05 part by weight |
| Methyl ethyl ketone | 40 g |
| Ethylene glycol monomethyl ether | 20 g |
| Propylene glycol monomethyl ether | 55 g |
| Water | 5 g |

A silicone rubber composition comprising the following components was applied, in an amount of 2.0 g/m$^2$ (on dry basis), to the photosensitive layer and then dried at 140 °C for 2 min to form a cured silicone rubber layer:

| | |
|---|---|
| α,ω-Divinylpolydimethylsiloxane (average molecular weight: 300,000) | 90 parts by weight |
| α,ω-Dimethylpolymethylhydrogensiloxane (average molecular weight: 2,500) | 6 parts by weight |
| Olefin/chloroplatinic acid (10% solution in toluene) | 20 parts by weight |
| Inhibitor (10% solution in toluene) | 10 parts by weight |
| Isopar G (a product of Esso Kagaku Co., Ltd.) | 1400 parts by weight |
| Toluene | 210 parts by weight |

A polypropylene film having a thickness of 9 μ m, which surface had been matted, was applied to the surface of the thus formed silicone rubber layer to form a laminate, i.e. the waterless photosensitive lithographic plate.

A positive film was placed on the lithographic plate and they were bonded under vacuum. After exposure with FT 26V UDNS LUTRA-PLUS FLIP-TOP PLATE MAKER (a product of Nuark Co. Ltd.) for 30 counts, the film was peeled off. The plate immersed in a developer comprising 8 parts by weight of benzyl alcohol, 3 parts by weight of sodium isopropylnaphthalenesulfonate, 1 part by weight of sodium carbonate and 88 parts by weight of water for 1 min, and then lightly rubbed with a developing pad to remove the photosensitive layer and the silicone rubber layer in the unexposed area. Thus, the waterless lithographic plate having the image of the positive film which was faithfully reproduced all over the surface thereof, was formed.

The plate was used for printing with TOYO KING ULTRA TUK aqualess G Sumi Ink by means of a Heidelberg GTO printer, of which a water-feeding means was dismantled. Prints with a faithful image reproducibility were obtained.

Example 2

A composition for forming a primer layer which comprised the following components was applied to a degreased aluminum sheet having a thickness of 0.3 mm and then dried at 140° C for 1 min, the amount of the composition being 4 g/$m^2$ after drying:

| | |
|---|---|
| Epikote 1255-HX-30 (30% solution) (condensate of bisphenol A and epichlorohydrin; a product of Yuka Shell Epoxy Co., Ltd.) | 5 parts by weight |
| Takenate D-110 N (75% solution) (a polyfunctional isocyanate compound of Takeda Chemical Industries, Ltd.) | 1.5 parts by weight |
| Pentaerythritol triacrylate | 1 part by weight |
| Ethyl 7-methylthioxanthone-3-carboxylate | 0.5 part by weight |
| Victoria Pure Blue BOH | 0.005 part by weight |
| 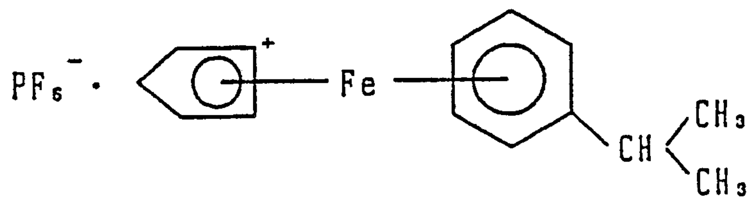 | 0.01 part by weight |
| Methyl ethyl ketone | 30 parts by weight |
| Propylene glycol monomethyl ether acetate | 30 parts by weight |

21.8 g of polyvinyl cinnamate, 0.3 g of 2,2′-azobis(2,4-dimethylvaleronitrile), 5.3 g of 3-methylpropionic acid and 40 g of methyl ethyl ketone were subjected to the reaction at 60°C for 5 hr. After completion of the reaction, 60 g of methyl ethyl ketone was added to the reaction mixture to dilute it, and then the mixture was thrown into water to precipitate the polymer. The polymer had an acid value of 107 and a weight-average molecular weight (determined by GPC, i.e. gel permeation chromatography) of 103,000. This polymer will be referred to as 'Polymer (A)'.

A photosensitive composition comprising the following components including Polymer (A) was prepared and was applied to an aluminum sheet on which the above-described primer layer was formed with a wheeler, and then dried at 100°C for 1 min. The amount of the thus formed layer was 1.0 g/m$^2$ (on dry basis).

| | |
|---|---|
| Polymer (A) | 3 parts by weight |
| $PF_6$ salt of condensate of p-diazodiphenylamine and formaldehyde | 0.1 part by weight |
| 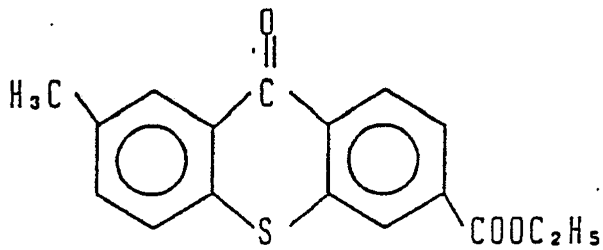 | 0.3 part by weight |
| Dihexyl phthalate | 0.2 part by weight |
| Megafac F 177 (fluorine-containing nonionic surfactant of Dainippon Ink & Chemicals, Inc.) | 0.02 part by weight |
| Crystal Violet | 0.05 part by weight |
| Ethylene glycol monomethyl ether | 10 parts by weight |
| Methyl ethyl ketone | 40 parts by weight |
| Propylene glycol monomethyl ether | 50 parts by weight |
| Water | 5 parts by weight |

Thereafter, a silicone rubber composition comprising the following components was applied, in an amount of 1.7 g/m² (on dry basis), to the photosensitive layer and then dried at 140° C for 2 min to form a cured silicone rubber layer:

| | |
|---|---|
| α,ω-Divinylpolydimethyl siloxane (average molecular weight: 600,000) | 90 parts by weight |
| α,ω-Dimethylpolyhydrogen siloxane (average molecular weight: 2,500) | 3 parts by weight |
| Olefin/chloroplatinic acid (10% solution in toluene) | 20 parts by weight |
| Inhibitor (10% solution in toluene) | 10 parts by weight |
| Isopar G (a product of Esso Kagaku Co., Ltd.) | 1400 parts by weight |
| Toluene | 210 parts by weight |

A polypropylene film having a thickness of 12 μ m, which surface had been matted, was applied to the surface of the thus formed silicone rubber layer to form a laminate, i.e. the waterless lithographic plate.

This plate was exposed in the same manner as that of Example 1 to form an image and then immersed in the same developer comprising the weak alkaline aqueous solution as that of Example 1 for 1 min. The plate surface was rubbed with a developing pad to remove the silicone rubber layer and the photosensitive

layer in the unexposed area. Thus, the waterless lithographic plate having the image of the positive film faithfully which was reproduced all over the surface thereof, was formed.

Example 3

1.0 g/m² (on dry basis) of a photosensitive solution comprising the following components was applied to the same aluminum support as that of Example 1 on which 8 g/m² of casein primer layer had been formed and then it was dried at 100 °C for 1 min:

| | |
|---|---|
| 10% Solution of Polymer (A) prepared in Example 2 and neutralized with sodium hydroxide in methyl cellosolve | 90 parts by weight |
| Ethyl 7-methylthioxanthone-3-carboxylate | 1 part by weight |
| 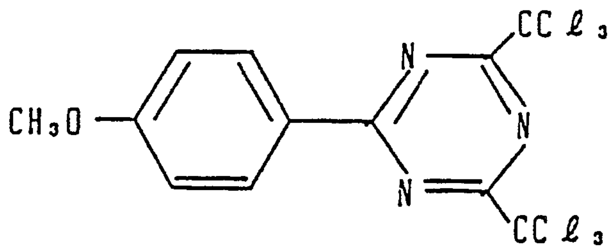 | 0.5 part by weight |
| Leuco Crystal Violet | 0.1 part by weight |
| Methyl ethyl ketone | 60 parts by weight |
| Fluorine-containing nonionic surfactant | 0.02 part by weight |

Thereafter, a silicone rubber composition comprising the following components was applied, in an amount of 1.4 g/m² (on dry basis), to the photosensitive layer and then dried at 140 °C for 2 min, to form a cured silicone rubber layer:

| | |
|---|---|
| α,ω-Divinyl polydimethylsiloxane (average molecular weight: 600,000) | 90 parts by weight |
| α,ω-Dimethyl polymethylhydrogensiloxane (average molecular weight: 2,500) | 5 parts by weight |
| Olefin/chloroplatinic acid (10% solution in toluene) | 20 parts by weight |
| Inhibitor (10% solution in toluene) | 10 parts by weight |
| $CH_2=CHCH_2\text{-}Si(OCH_3)_3$ | 1 part by weight |
| KF 410 (a silicone releasing agent of Shin-Etsu Chemical Co., Ltd.) | 0.5 part by weight |
| Isopar G (a product of Esso Kagaku Co., Ltd.) | 1400 parts by weight |
| Toluene | 210 parts by weight |

A polyethylene terephthalate film having a thickness of 8 µm was applied to the thus formed plate to form a laminate, i.e. the lithographic plate.

This plate was exposed in the same manner as that of Example 1 to form an image and then immersed in warm water at 50 °C for 30 sec. The plate surface was rubbed with a sponge for 30 sec to remove the silicone rubber layer and the photosensitive layer in the unexposed area. Thus, the waterless lithographic plate having the image of the positive film which was faithfully reproduced all over the surface thereof, was formed.

Example 4

The same procedure as that of Example 1 was repeated except that a photosensitive composition comprising the following components was used:

| | |
|---|---|
| Methyl methacrylate /N-[2-(methacryloyloxy)ethyl]-2,3-dimethylmaleimide/methacrylic acid copolymer (weight ratio: 15/65/20) | 90 parts by weight |
| Ethyl 7-methylthioxanthone-3-carboxylate | 10 parts by weight |
| Propylene glycol monomethyl ether acetate | 1100 parts by weight |
| Methyl ethyl ketone | 1100 parts by weight |

The plate was used for printing with TOYO KING ULTRA TUK aqualess G Sumi Ink by means of a Heidelberg GTO printer, of which a water-feeding means was dismantled. Prints with a faithful image reproducibility were obtained.

Example 5

4 g/m$^2$ (on dry basis) of a composition for forming a photosensitive primer layer, which comprised the following components, was applied to a degreased aluminum sheet having a thickness of 0.3 mm and then dried at 140°C for 1 min:

| | |
|---|---|
| Epikote 1255-HX-30 (30% solution) (condensate of bisphenol A and epichlorohydrin; a product of Yuka Shell Epoxy Co., Ltd.) | 5 g |
| Takenate D-110 N (75% solution) (a polyfunctional isocyanate compound of Takeda Chemical Industries, Ltd.) | 1.5 g |

| | |
|---|---|
| Pentaerythritol triacrylate | 1 g |
| Ethyl 7-methylthioxanthone-3-carboxylate | 0.5 g |
| Victoria Pure Blue BOH | 0.005 g |
| 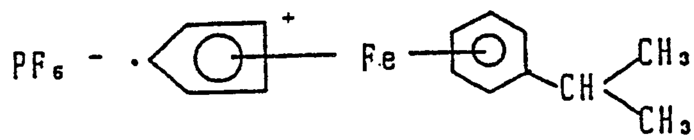 | 0.01 g |
| Methyl ethyl ketone | 30 g |
| Propylene glycol monomethyl ether acetate | 30 g |

1.0 g/m$^2$ (on dry basis) of a water-soluble photosensitive solution comprising the following components was then applied thereto and dried at 100° C for 1 min:

| | |
|---|---|
| Sodium salt of N-[2-(methacryloyloxy)ethyl]-2,3-dimethylmaleimide/2-hydroxyethyl methacrylate/methacrylic acid copolymer (weight ratio: 70/20/10) (10% aqueous solution) | 50 g |
| Water | 40 g |
| Methanol | 10 g |

Thereafter, a silicone rubber composition comprising the following components was applied, in an amount of 1.2 g/m$^2$ (on dry basis), to the photosensitive layer and then dried at 140° C for 2 min, to form a cured silicone rubber layer:

| | |
|---|---|
| α,ω-Divinylpolydimethylsiloxane (average molecular weight: 600,000) | 90 parts by weight |
| α,ω-Dimethylpolymethylhydrogensiloxane (average molecular weight: 2,500) | 3 parts by weight |
| Olefin/chloroplatinic acid (10% solution in toluene) | 20 parts by weight |
| Inhibitor (10% solution in toluene) | 10 parts by weight |
| Isopar G (a product of EXXON Kagaku Co.) | 1400 parts by weight |
| Toluene | 210 parts by weight |

A polypropylene film having a thickness of 12 m, which surface had been matted, was applied to the surface of the thus formed silicone rubber layer to form a laminate, i.e. the waterless lithographic plate.

This plate was exposed in the same manner as that of Example 1 to form an image and then immersed in warm water at 50° C for 30 sec. The plate surface was rubbed with a sponge for 30 sec to remove the silicone rubber layer and the photosensitive layer in the unexposed area. Thus, the waterless lithographic plate having the image of the positive film which was faithfully reproduced all over the surface thereof, was formed.

Example 6

1.0 g/m$^2$ (on dry basis) of a photosensitive solution comprising the following components was applied to the same aluminum support as that of Example 1, on which 8 g/m$^2$ of casein primer layer had been formed, and then it was dried at 100° C for 1 min.

| | |
|---|---|
| Sodium salt of methyl methacrylate/N-[2-(methacryloyloxy)ethyl]-2,3-dimethylmaleimide/methacrylic acid (15/65/20) | 5 parts by weight |
| Ethyl 7-methylthioxanthone-3-carboxylate | 0.5 parts by weight |
| 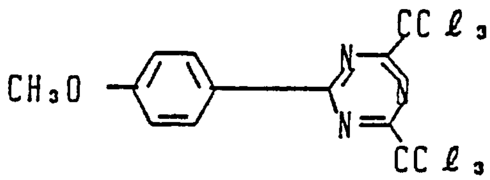 | 0.2 part by weight |
| Leuco Crystal Violet | 0.05 part by weight |
| Methyl ethyl ketone | 35 parts by weight |
| Propylene glycol monomethyl ether acetate | 25 parts by weight |
| Fluorine-containing nonionic surfactant | 0.01 part by weight |

Then, 2.0 g/m$^2$ (on dry basis) of a silicone rubber composition comprising the following components was applied to the photosensitive layer and then dried at 140°C for 2 min, to form a cured silicone rubber layer:

| | |
|---|---|
| α,ω-Divinyl polydimethylsiloxane (average molecular weight: 600,000) | 90 parts by weight |
| α,ω-Dimethyl polymethylhydrogensiloxane (average molecular weight: 2,500) | 5 parts by weight |
| Olefin/chloroplatinic acid (10% solution in toluene) | 20 parts by weight |
| Inhibitor (10% solution in toluene) | 10 parts by weight |
| $CH_2=CHCH_2-Si(OCH_3)_3$ | 1 part by weight |
| KF 410 (a silicone releasing agent of Shin-Etsu Chemicl Co., Ltd.) | 0.5 part by weight |
| Isopar G (a product of Esso Kagaku Co., Ltd.) | 1500 parts by weight |
| Toluene | 210 parts by weight |

A polyethylene terephthalate film having a thickness of 8 μm was applied to the thus formed plate, to form a laminate, i.e. the lithographic plate.

This plate was exposed through a positive film and then developed with a developer comprising the following components:

| | |
|---|---|
| Benzyl alcohol | 8 parts by weight |
| 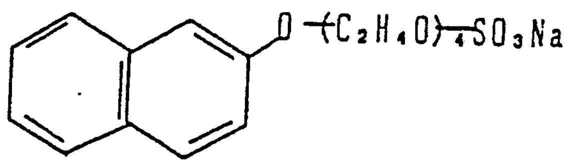 | 5 parts by weight |
| Water | 87 parts by weight |

Then, only the primer layer in the unexposed area was dyed with a dyeing solution comprising the following components, to form a waterless lithographic plate having an excellent image reproducibility:

| | |
|---|---|
| Water | 99.5 parts by weight |
| Crystal Violet | 0.5 part by weight |

Example 7

The casein primer formed in Example 6 was replaced with a layer formed by applying 8 g/m[2] (on dry basis) of a casein solution comprising the following components and drying it at 120 °C for 1 min.

| | |
|---|---|
| Casein | 60 parts by weight |
| $Na_2CO_3$ | 4.2 parts by weight |
| 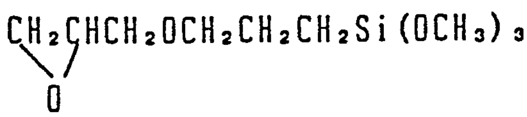 | 1.5 parts by weight |
| 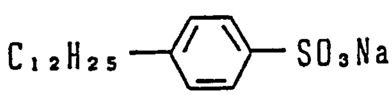 | 0.1 part by weight |
| $TiO_2$-dispersed gelatin ($TiO_2$ content: 56 wt.%) | 10 parts by weight |
| Tartrazine | 2 parts by weight |
| Water | 1000 parts by weight |

A casein hardener solution comprising the following components was applied thereto and then dried at 120 °C for 1 min:

| | |
|---|---|
| Water | 30 parts by weight |
| Methanol | 70 parts by weight |
| $CH_2 = CHSO_2CH_2CHCH_2SO_2CH = CH_2$ OH | 2 parts by weight |

A waterless lithographic plate having an excellent tone reproducibility was formed in the same manner as that of Example 6 except that the thus formed aluminum support having the primer layer was used.

## Claims

1. A lithographic plate necessitating no dampening water which comprises, on a support, a photosensitive layer and a silicone rubber layer in this order, said silicone rubber layer being formed by addition reaction of an $\geq$SiH group with a -CH=CH- group to cause crosslinking, characterized in that said photosensitive layer comprises a water-soluble or aqueous alkali solution-soluble photosensitive polymer having, in its side chain,

(1) at least two groups represented by the following general formulae (I) to (III):

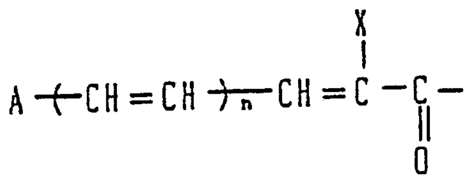

. . . ( I )

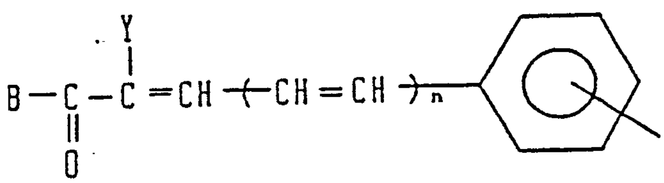

. . . ( II )

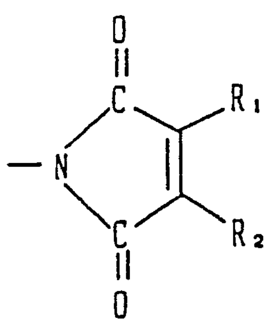

. . . (III)

wherein
A presents an aryl group, a substituted aryl group, a furyl group or a thienyl group,
B represents a hydroxyl group, an alkoxy group, aryl group, a substituted aryl group or an alkyl group,
X represents H, CN, a halogen atom, a phenyl group, an alkyl group or $-\underset{\underset{O}{\|}}{C}-$,
Y represents H, CN, a halogen atom, a phenyl group or an alkyl group,
n represents 0 or 1, and
$R_1$ and $R_2$ each represents an alkyl group or $R_1$ and $R_2$ may together form a five-membered or six-membered ring, and

(2) at least one carboxylic acid group or its salt.

2. The lithographic plate of claim 1, wherein said polymer is a copolymer obtained from:

(a) an acrylate, a methacrylate or a vinylether having the formula (I) or (II),

(b) an $\alpha,\beta$-unsaturated carboxylic acid, and

(c) if necessary, an addition-polymerizable monomer.

3. The lithographic plate of claim 2, wherein the component (a) is selected from the group consisting of:

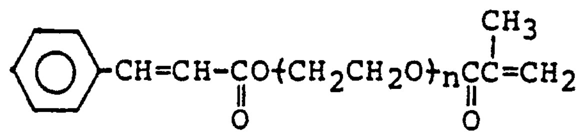

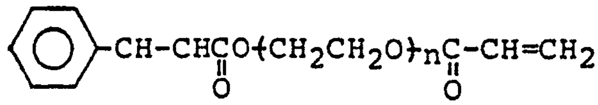

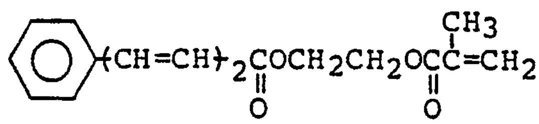

, and

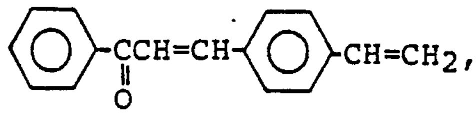

wherein n is 1 - 10.

4. The lithographic plate of claim 3, wherein said number n is 1 to 4.

5. The lithographic plate of claim 1, wherein said polymer having, its side chain, at least two groups represented by the formula (I) or (II) and at least one carboxylic acid group or its salt has a molecular weight of 2000 to 500,000.

6. The lithographic plate of claim 5, wherein said polymer has a molecular weight of 10,000 to 150,000.

7. The lithographic plate of claim 1, wherein the groups $R_1$ and $R_2$ in the formula (III) each represents an alkyl group having 1 to 4 carbon atoms.

8. The lithogrpahic plate of claim 1, wherein said polymer having, in its side chain, at least two groups represented by the formula (III) and at least one carboxylic acid group or its salt is a copolymer prepared from:

(a) one member selected from the following monomers:

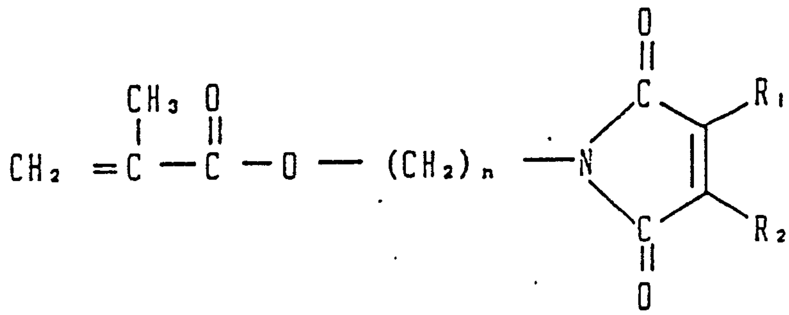

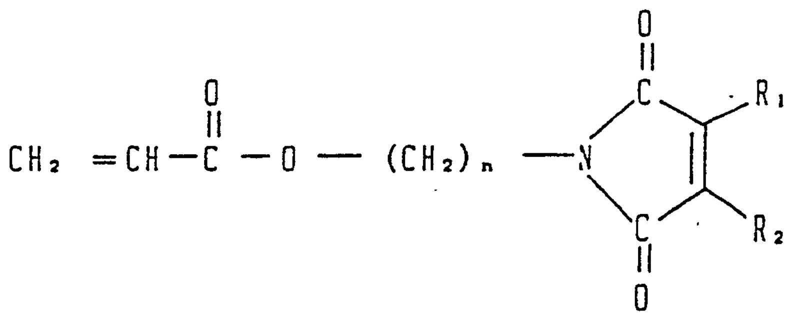

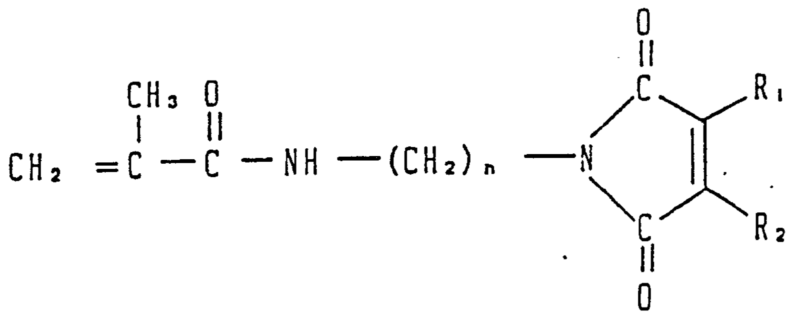

and

(b) one member selected from the group consisting of acrylic acid, methacrylic acid, crotonic acid and itaconic acid.

9. The lithographic plate of claim 1, wherein said polymer having, in its side chain, at least two groups represented by the formula (III) and at least one carboxylic acid group or its salt has a molecular weight of at least 1000.

10. The lithographic plate of claim 9, wherein said polymer has a molecular weight of 10,000 to 500,000.